# EUROPÄISCHE PATENTSCHRIFT

(11) **EP 1 873 610 B1**
(45) Veröffentlichungstag und Bekanntmachung des Hinweises auf die Patenterteilung: **13.06.2012**
(21) Anmeldenummer: 07118708.2
(22) Anmeldetag: 21.07.2003
(51) Int. Cl.: G05G 1/02, G05G 1/08, H01H 36/00, H03K 17/96, F24C 7/08, H01H 25/00, H03K 17/97, H05B 3/74

(54) **Bedieneinheit für ein elektrisches Haushaltsgerät**
Control unit for electric household appliance
Unité de commande pour appareil ménager électrique

(30) Priorität: 14.08.2002 DE 10237289
(43) Veröffentlichungstag der Anmeldung: 02.01.2008
(62) Teilanmeldung aus: 03792219.2
(73) Patentinhaber: BSH Bosch und Siemens Hausgeräte GmbH, 81739 München (DE)
(72) Erfinder: Blumenthal, Peter, 83278 Traunstein (DE); Reinker, Bernward, 93128 Regenstauf (DE); Stitzl, Bernd, 83362 Surberg (DE)

(56) Entgegenhaltungen:
- EP-A- 0 041 830
- EP-A- 1 014 001
- EP-A- 1 347 242
- DE-A- 19 906 365
- DE-A1- 10 255 676
- US-A- 5 920 131

## Beschreibung

Die vorliegende Erfindung betrifft eine Bedieneinheit für ein elektrisches Haushaltsgerät zum Einstellen von Betriebsfunktionen und -parametern mit einem an einer Bedienfläche gehalterten Bedienknebel, der zum Auswählen einer Betriebsfunktion, wie der Auswahl einer Kochstelle, aus einer Ausgangsstellung in eine Auswahlstellung verschiebbar ist und der zum Einstellen des Betriebsparameters, wie einer Heizstufe, um eine Knebelachse drehbar ist.

Eine gattungsgemäße Bedieneinheit für ein elektrisches Haushaltsgerät ist in der EP 0 962 707 A1 beschrieben. Ein an einer Bedienfläche gehalterter Bedienknebel dient zum Einstellen von Betriebsfunktionen, bspw. zum Auswählen einer bestimmten Kochstelle eines elektrischen Herdes und kann zu diesem Zweck aus einer Ausgangsstellung in eine Auswahlstellung geschoben bzw. geschwenkt werden. Zum Einstellen eines Betriebsparameters, bspw. einer Heizstufe kann der Bedienknebel weiterhin um eine Knebelachse gedreht werden. Eine Ausführungsform dieser gattungsgemäßen Bedieneinheit sieht eine geschlossene Bedienfläche vor, an welcher der Bedienknebel abnehmbar mittels Magnetkraft gehaltert ist. Die maximal zulässigen Verschiebewege sind hierbei durch einen in eine Führungskulisse der Bedienfläche eingreifenden und dort entlang gleitenden Führungszapfen des Bedienknebels vorgegeben. US 5,920,131 offenbart eine Bedieneinheit nach dem Oberbegriff des Anspruchs 1.

Die Aufgabe der vorliegenden Erfindung besteht darin, eine Bedieneinheit nach dem Oberbegriff des Patentanspruchs 1 so zu verbessern, dass sich eine leichte Bedienbarkeit sowie eine einfach aufgebaute und in der Funktion verbesserte Koppelung mit dem Haushaltsgerät ergibt.

Erfindungsgemäß wird diese Aufgabe bei einer Bedieneinheit nach dem Oberbegriff des Anspruchs 1 dadurch gelöst, dass zur magnetischen Halterung des Bedienknebels im Bereich der Platte eine Magnetanordnung mit mehreren ortsfest angeordneten Magneten vorgesehen ist, die auf wenigstens einen Permanentmagneten und/oder ein ferromagnetisches Element des Bedienknebels eine magnetische Anziehungskraft ausübt und Dreh- und Verschiebebewegungen des Bedienknebels ermöglicht, und dass mit zusätzlichen Berührungssensaren ein unabhängiger Hauptschalter realisiert ist, wobei beim Abnehmen des Bedienknebels während des Betriebs die Kochstellen abscheltbar sind. Mit einer solchen erfindungsgemäßen Bedieneinheit ist eine einfache und übersichtliche Bedienung des elektrischen Haushaltsgeräts ermöglicht. So kann durch Verschieben des Bedienknebels aus einer Ausgangsstellung in eine Auswahlstellung eine Betriebsfunktion ausgewählt werden, die beispielsweise in der Auswahl einer bestimmten Kochstelle eines elektrischen Herdes besteht. Durch Drehen des Bedienknebels in herkömmlicher Art und Weise kann ein Betriebsparameter der zuvor ausgewählten Betriebsfunktion beeinflusst werden. Durch Drehen des Bedienknebels um seine Knebelachse kann beispielsweise eine Heizstufe der zuvor ausgewählten Kochstelle beeinflusst werden. Der Bedienknebel kann vom ersten Bedienschritt, der Auswahl der Betriebsfunktion bis zum zweiten Bedienschritt, dem Einstellen des Betriebsparameters der ausgewählten Betriebsfunktion, unverändert in der Hand einer Bedienperson verbleiben. Ein Griffwechsel oder die Betätigung eines Zusatzelementes der Bedieneinheit ist nicht erforderlich. Zudem ist jedem Bedienschritt eine eigene, charakteristische Bewegungsart des Bedienknebels zugeordnet. Durch die zusammenwirkenden Permanentmagneten der Bedienfläche und des Bedienknebels kann dieser von der Platte abgezogen werden und nahezu beliebig auf der Platte verschoben und/oder verdreht werden. Die Platte kann völlig plan ausgestaltet sein und kann auf diese Weise optimal von anhaftendem Schmutz gereinigt werden. Alle möglichen Verschiebe- und Drehbewegungen des Bedienknebels werden ausschließlich durch die Gestaltung der zusammenwirkenden magnetischen Elemente definiert. Erfindungsgemäß ist eine Verbindung dieser Funktionalität des Bedienknebels mit zusätzlichen Berührungssensoren möglich.

Eine Anschlagsstellung in jeweils einer der Auswahlstellungen kann gemäß einer Ausgestaltung der Erfindung durch ein optisches und/oder akustische Signal angezeigt werden. Auf diese Weise wird der Bedienperson angezeigt, dass sich der Bedienknebel in der Auswahlstellung befindet und nicht weiter über diese hinausgeschoben werden sollte. Eine Sicherheitsfunktion kann beispielsweise darin bestehen, dass die zuvor angewählte Betriebsfunktion bei Abnehmen des Bedienknebels oder bei zu weitem Schieben über seine Anschlagstellung hinaus abgeschaltet wird.

Die Abtastung und Erfassung der Verschiebe- und Drehbewegungen des Bedienknebels kann in an sich bekannter Weise auf induktivem, auf optischem oder auf magnetischem Wege erfolgen. Die erwähnten Abtastverfahren können ggf. auch miteinander kombiniert werden.

Eine erste Ausgestaltung der Erfindung sieht vor, dass der Bedienknebel aus jeder der Auswahlstelllungen selbsttätig in die Ausgangsstellung zurückgleitet. Eine alternative Ausgestaltung kann darin bestehen, dass der Bedienknebel in jeder oder nur in einigen der Auswahlstellungen verbleibt und aus diesen durch Zurückschieben in die Ausgangsstellung gebracht werden muss. Diese alternativen Konfigurationen können jeweils durch geeignete Gestaltungen und Anordnungen der miteinander kommunizierenden magnetischen Elemente realisiert werden.

Vorzugsweise sind im Bereich der Platte ein Zentralmagnet und mehrere in einem vorgegebenen Abstand jeweils gleichmäßig ringförmig um diesen gruppierte Kranzmagneten vorgesehen. Jeder der Kranzmagneten definiert eine der möglichen Auswahlstellungen, in die der Bedienknebel geschoben werden kann. Bei vier vorhandenen Betriebsfunktionen, beispielsweise vier Kochstellen eines elektrischen Herdes, sind wenigstens vier verschiedene Auswahlstellungen notwendig. In einer vorteilhaften Weiterbildung der Erfindung können jedoch zusätzliche Auswahlstellungen vorgesehen sein, die mit Zusatzfunktionen belegt sind. So können beispielsweise bei einem elektrischen Herd sechs Auswahlstellungen zur Auswahl von vier Kochstellen sowie zur Steuerung von Zusatzfunktionen vorgesehen sein. Solche Zusatzfunktionen können beispielsweise eine Timersteuerung, eine zentrale Zonenzuschaltung oder dergleichen sein. Sind sechs solcher Auswahlstellungen vorgesehen, sind entsprechend sechs um den Zentralmagneten gruppierte Kranzmagneten notwendig.

Eine Ausgestaltung der Erfindung sieht an einer Unterseite des Bedienknebels einen Haltemagneten sowie eine ferromagnetische Scheibe mit wenigstens drei Armen vor. Vorzugsweise weist die ferromagnetische Scheibe, die beispielsweise als Polspinne aus Weicheisen ausgebildet sein kann, ebenso viele Arme auf, wie Kranzmagneten in bzw. an der Bedienfläche vorhanden sind. Die Polspinne aus Weicheisen bewirkt eine Magnetisierung der Arme in einer zur Unterseite des Haltemagneten entgegengesetzten Polung. Auf diese Weise können die Positionierungen der Arme auf den entsprechenden Kranzmagneten eine Abstoßung oder Anziehung bewirken, je nachdem wie die Kranzmagneten orientiert sind. Vorzugsweise sind die Kranzmagneten in gleicher Polung angeordnet wie der Zentralmagnet der Bedienfläche. Auf diese Weise kann der Bedienknebel mit seinen Haltemagneten auf einen der Kranzmagneten geschoben werden und unterliegt dabei einer magnetischen Anziehung. Da die Polspinne aus Weicheisen vorzugsweise die entgegengesetzte Polung wie die Unterseite des Bedienknebels aufweist, wird beim Drehen des Bedienknebels eine Rastung bewirkt, die durch die abstoßenden Kräfte beim Überstreichen der Arme der Polspinne über die Kranzmagneten bzw. den Zentralmagneten bewirkt wird.

Zur Steuerung von zwei oder drei Betriebsfunktionen kann wahlweise jeweils ein Bedienknebel vorgesehen sein, der dem entsprechend zwei oder drei Auswahlstellungen aufweist. Ebenso kann ein Bedienknebel mehrere Auswahlstellungen, beispielsweise sechs oder acht, aufweisen, so dass zur umfassenden Steuerung eines elektrischen Geräts ein Bedienknebel ausreichen kann.

Besonders vorteilhaft ist es, wenn in einem Abstand vom Außenumfang des Zentralmagneten ein Aktivierungsbereich vorgesehen ist, in den der Bedienknebel zum Auswählen der Bedienfunktion geschoben werden muß. Der Abstand zum Aktivierungsbereich verhindert, dass der Bedienknebel bei einer Drehbewegung in seiner Ausgangsstellung unbeabsichtigt in die Auswahlstellung verschoben wird. Daher ist eine gewisse exzentrische Drehbewegung des Bedienknebels in seiner Ausgangsstellung ermöglicht, ohne unbeabsichtigt eine Auswahlstellung auszuwählen. Als besonders vorteilhaft hat sich ein Abstand zwischen dem Aktivierungsbereich und dem Zentralmagneten von zumindest 5 mm erwiesen.

Ferner ist es von Vorteil, wenn eine äußere Begrenzung des Aktivierungsbereiches etwa bis zu 15 mm von dem Umfang des Zentralmagneten beabstandet ist. Dadurch sind noch ausreichend große magnetische Rückstellkräfte des Zentralmagneten gewährleistet, um ein Zurückstellen des Bedienknebels vom Aktivierungsbereich in die Ausgangsstellung zu unterstützen. Außerdem ergibt sich daraus für die Bedienperson eine kurze und daher komfortable Auslenkweglänge des Bedienknebels. Zugleich ist der Platzbedarf der gesamten Bedieneinheit in dem Haushaltsgerät hinreichend reduziert. Die flächige Ausbildung des Aktivierungsbereiches gewährleistet zudem ein zuverlässiges Erfassen einer Verschiebebewegung des Bedienknebels. Dies ist insbesondere bei einer nur in Zeitintervallen erfolgenden induktiven und/oder optischen Abtastung des Bedienknebels von Bedeutung.

Sicherheitstechnisch vorteilhaft kann die mit dem Bedienknebel vorgenommene Auswahl einer Betriebsfunktion nur dann erfasst werden, wenn der Bedienknebel nach Ablauf eines vorgegebenen Zeitintervalles wieder in seine Ausgangsstellung zurückgestellt wird. Ist dies nicht der Fall, kann von einer Störung des Auswahlvorgangs ausgegangen werden. Das Zeitintervall liegt bevorzugt zwischen zwei bis fünf Sekunden.

Die Erfindung wird nachfolgend anhand von Ausführungsbeispielen der erfindungsgemäßen Bedieneinheit am Beispiel eines Kochfeldes beschrieben. Es zeigen:
- Figur 1: eine perspektivische Ansicht eines Kochfeldes mit einer Bedieneinheit,
- Figur 2: eine schematische Schnittansicht eines Bedienknebels der Bedieneinheit,
- Figur 3: eine Explosionsdarstellung der erfindungsgemäßen Bedieneinheit zur Verdeutlichung der zusammen wirkenden magnetischen Elemente der Bedienfläche und des Bedienknebels,
- Figuren 4 und 5: schematische Darstellungen der zusammen wirkenden magnetischen Elemente der Bedienfläche und des Bedienknebels und
- Figuren 6 und 7: Prinzipdarstellungen verschiedener Betätigungsvarianten der Bedieneinheit.

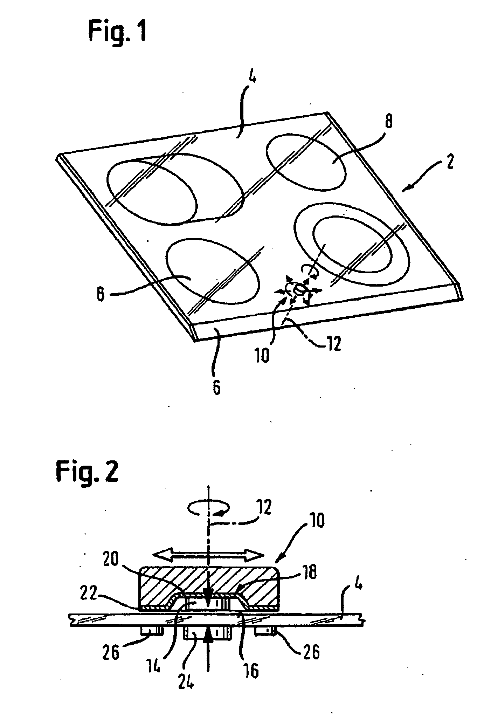

Figur 1 zeigt eine perspektivische Ansicht eines Kochfeldes 2 mit einer daran angeordneten Bedieneinheit in Gestalt eines Bedienknebels 10. Das Kochfeld 2 weist eine Glaskeramikplatte 4 auf, die frontseitig in einer Plattenfacette 6 endet. Auf der Glaskeramikplatte 4 sind im gezeigten Ausführungsbeispiel vier in an sich bekannter Weise beheizbare Kochstellen 8 vorgesehen, die mit Dekor entsprechend markiert sein können. In der frontseitigen Plattenfacette 6 oder auf der Oberfläche der Glaskeramikplatte 4 kann ein Anzeigeelement bzw. können mehrere Anzeigeelemente (nicht dargestellt) angebracht sein, die angewählte Betriebsfunktionen bzw. Betriebsparameter anzeigen. In einem mittigen vorderen Bereich der Glaskeramikplatte nahe der Plattenfacette 6 ist ein Bedienknebel 10 angeordnet, der um eine Knebelachse 12 gedreht und in verschiedene definierte Richtungen aus einer mittleren Ausgangsstellung in Auswahlstellungen verschoben werden kann.

Figur 2 zeigt eine schematische Schnittdarstellung der Glaskeramikplatte 4 mit dem darauf aufgebrachten Bedienknebel 10. Dieser ist mittels Magnetkraft auf der Glaskeramikplatte 4 gehaltert und kann parallel zu deren Oberfläche verschoben bzw. um seine Knebelachse 12 gedreht werden. Erfindungsgemäß sind die Verschiebebewegungen des Bedienknebels 10 in seinen verschiedenen Auswahlstellungen sowie die mögliche Drehbewegungen um seine Knebelachse 12 ausschließlich durch die Anordnung von Permanentmagneten bzw. eines oder mehrerer magnetischer Elemente im Bedienknebel 10 definiert. An der Unterseite der Glaskeramikplatte 4 ist ein Zentralmagnet 24 angeordnet, um den in einem definierten Abstand mehrere Kranzmagneten 26 gruppiert sind. Der Zentralmagnet 24 weist eine stärkere Magnetisierung auf als die Kranzmagneten 26, was durch die unterschiedliche Größe angedeutet ist. An einer Knebelunterseite 16 des Bedienknebels 10 ist mittig ein Haltemagnet 14 angebracht, der eine entgegengesetzte Polung zum Zentralmagneten 24 und vorzugsweise ungefähr eine gleiche Größe wie dieser aufweist. Ausgehend von einer der Knebelunterseite 16 abgewandten Oberseite des Haltemagneten 14 ist eine Polspinne 18 in Gestalt einer sternförmigen Scheibe mit nach außen weisenden Armen 22 angebracht, die vorzugsweise aus Weicheisen besteht und damit die gleiche Polung wie die Oberseite des Haltemagneten 14 aufweist. Da die Kranzmagneten 26 vorzugsweise in gleicher Polungsrichtung montiert sind wie der Zentralmagnet 24, bestehen zwischen den Armen 22 der Polspinne 18 und den Oberseiten der Kranzmagneten 26 jeweils abstoßende magnetische Kräfte.

Die Erfassung der Verschiebebewegungen des Bedienknebels 10 zur Auswahl der zur Verfügung stehenden Betriebsfunktionen sowie der Drehbewegungen zur Auswahl der zur Verfügung stehenden Betriebsparameter des elektrischen Haushaltsgeräts kann in bekannter Weise, bspw. mittels induktiver und/oder optischer Abtastung erfolgen. Diese Abtastverfahren ermöglichen jeweils eine präzise berührungsfreie Signalübertragung und damit eine zuverlässige Bedienung des elektrischen Haushaltsgeräts.

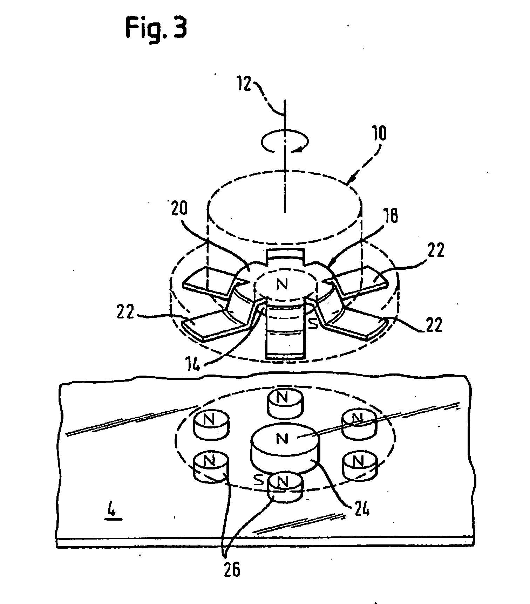

Figur 3 zeigt eine schematische Explosionsdarstellung des von der Oberfläche der Glaskeramikplatte 4 abgehobenen Bedienknebels 10. In dieser perspektivischen Darstellung sind die Gruppierung der Permanentmagneten unterhalb der Glaskeramikplatte 4 sowie die Anordnung der magnetischen Elemente des Bedienknebels 10 gut erkennbar. Im gezeigten Ausführungsbeispiels sind sechs jeweils gleichmäßig in gleichem Abstand um den Zentralmagneten 24 gruppierte Kranzmagneten 26 vorgesehen, deren Nordpol N nach oben in Richtung zum Bedienknebel 10 und deren Südpol S in entgegengesetzte Richtung weist. Der Zentralmagnet 24 weist die gleiche Polung mit dem Nordpol N nach oben auf. Der Südpol S des Haltemagneten 14 des Bedienknebels 10 weist zur Knebelunterseite 16 und wird daher vom Zentralmagneten 24 angezogen. Die von einem Zentralbereich 20 auf dem Nordpol N des Haltemagneten 14 aufliegenden und seitlich nach unten gezogenen Armen 22 der Polspinne 18 weisen eine gleich gerichtete Polung auf wie die Oberseite des Haltemagneten 14 und werden daher von den Kranzmagneten 26 jeweils abgestoßen. Diese abstoßenden Wirkung zwischen den Armen 22 und den Kranzmagneten 26 bewirkt somit eine Anzahl von Raststellungen des um seine Knebelachse 12 gedrehten Bedienknebels 10. Im gezeigten Ausführungsbeispiel sind dies sechs Raststufen. Der Bedienknebel kann wahlweise mit seinem Haltemagneten 14 über einen der Kranzmagneten 26 geschoben werden und befindet sich damit in einer von sechs Auswahlstellungen. Je nach dem gewählten Abstand zwischen den Kranzmagneten 26 und dem Zentralmagneten 24 gleitet der Bedienknebel 10 nach dem Loslassen selbsttätig in seine Ausgangsstellung zurück, in der sich Haltemagnet 14 und Zentralmagnet 24 deckungsgleich übereinander befinden. Bei ausreichend groß gewähltem Abstand zwischen Zentralmagnet 24 und Kranzmagneten 26 wird die vom Zentralmagneten auf den Haltemagneten 14 ausgeübte magnetische Kraft zu schwach, so dass dieser in seiner gewählten Auswahlstellung verbleibt und in die Ausgangsstellung zurückgeschoben werden muss.

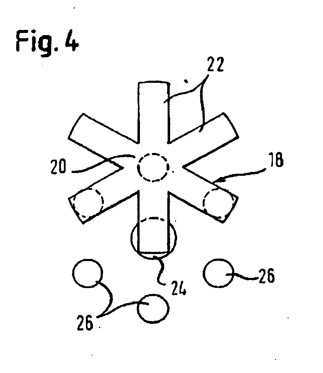

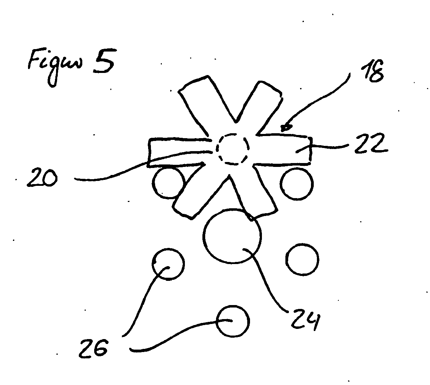

Die Figuren 4 und 5 verdeutlichen in schematischen Darstellungen die Anordnung der Polspinne 18 relativ zu den Magneten 24, 26 der Bedienfläche. Die Polspinne 4 befindet sich dabei mit ihrem Zentralbereich 20, unter dem der Haltemagnete 14 angeordnet ist, jeweils über dem obersten von sechs Kranzmagneten 26. In Figur 4 ist die Situation einer abstoßenden magnetischen Kraft zwischen den beiden dem obersten benachbarten Kranzmagneten 26 und den Armen 22 der Polspinne 18 gezeigt. Figur 5 verdeutlicht eine Ruheposition des Bedienknebels, bei dem sich die Arme 22 der Polspinne 18 jeweils in Zwischenräumen zwischen benachbarten Kranzmagneten 26 der Bedienfläche befinden. Ein typischer Auslenkweg kann zwischen 3 und 20 mm liegen.

In der Figur 5 ist mit gestrichelten Linien ein Aktivierungsbereich 32 dargestellt. Innerhalb des Aktivierungsbereiches 32 sind die sechs Kranzmagnete 26 angeordnet. Eine innere erste Begrenzung 33 des ringförmigen Aktivierungsbereiches 32 erstreckt sich in einem Abstand a1 von 5 mm konzentrisch um den Zentralmagneten 24. Zum Auswählen einer der den Kranzmagneten 26 zugeordneten Auswahlstellungen 30 muss der Bedienknebel 10 in den Aktivierungsbereich 32 geschoben werden. Der Abstand a1 ist derart bemessen, dass exzentrische Drehbewegungen des Bedienknebels in seiner Ausgangsstellung kein unbeabsichtigtes Auslenken des Bedienknebels 10 zu den Kranzmagneten 26 ergeben. Eine äußere zweite Begrenzung 34 des Aktivierungsbereiches 32 erstreckt sich gemäß der Figur 5 konzentrisch um die innere Begrenzung 33 und ist über einen Abstand a2 von 15 mm in radialer Richtung von dem Außenumfang des Zentralmagneten 24 beabstandet. Befindet sich der Bedienknebel 10 zwischen den ersten und zweiten Begrenzungen 33, 34 des Aktivierungsbereiches 32, so sind die magnetischen Rückstellkräfte des Zentralmagneten 24 noch ausreichend groß, um eine Rückstellung des Bedienknebels 10 in seine Ausgangsstellung 28 zu unterstützen.

Aus sicherheitstechnischen Gründen darf gemäß dem Ausführungsbeispiel der Figur 5 der gesamte Auswahlvorgang des Bedienknebels nicht länger als 2 Sekunden andauern. Bei einem Überschreiten des Zeitintervalls wird die Auswahl der Betriebsfunktion, etwa die Auswahl einer der Kochstellen 8, nicht erfasst.

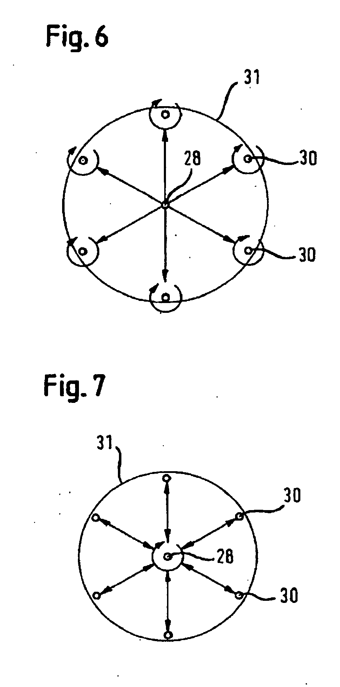

Während des Auslenkvorgangs ist eine optische und/oder akustische Quittierung mittels einer Signaleinrichtung 31, wie in Figur 6 und 7 gezeigt, bei einer festgelegten Auslenkweite sinnvoll. Sie fordert den Benutzer auf, den Bedienknebel nicht noch weiter auszulenken, sondern ihn in dieser Stellung zu belassen oder in seine Mittenposition selbsttätig durch magnetische Zurückstellkräfte zurückgleiten zu lassen. Bei einer optischen Quittierung wird vorzugsweise ein ringförmiges Leuchtsegment 31 bei der festgelegten Auslenkweite und Auslenkrichtung als optischer Anschlag benutzt. Das Leuchtsegment leuchtet bevorzugt in dem Augenblick auf, wo der Rand des Bedienknebels die festgelegte Auslenkweite gerade erreicht hat. Die Lichtmarke unter der Glaskeramikabdeckung wird dabei gerade vom Rand des Bedienknebels erreicht, ohne sie zu überdecken. Unterstützend kann in diesem Augenblick ein kurzer Signalton eingesetzt werden. Bei einer ausschließlich vorgesehenen akustischen Quittierung wird die gleiche Funktionalität ohne Lichtmarke erfüllt. Beide Quittierungsarten können auch gemischt zur Anwendung kommen, um z.B. Hauptauslenkrichtungen von untergeordneten Auslenkrichtungen zu unterscheiden. In einer bevorzugten Ausgestaltung der Erfindung wird die Lichtmarkierung zur Auswahl von Kochstellen verwendet und leuchtet so lange, bis eine andere Kochstelle angewählt wird. Anschließend kann durch Drehen des Bedienknebels in der Mittenposition die Kochstufe der gewählten und angezeigten Kochstelle eingestellt und jederzeit ohne vorheriges Auslenken direkt verändert werden.

Zum Bedienen der Bedieneinheit kann der Drehknebel beispielsweise gemäß Figur 6 in einer Ansicht von oben aus der zentralen Ausgangsstellung 28 in sechs verschiedene Auswahlstellungen 30 geschoben werden. In diesen Auswahlstellungen 30 kann der Bedienknebel dann jeweils gedreht werden. Zur Verringerung der Heizstufe einer Kochstelle 8 kann der Bedienknebel somit in die entsprechende Auswahlstellung 30 geschoben und durch Drehen entgegen des Uhrzeigersinns gedreht werden. Aufgrund des ausreichenden Abstandes zwischen Zentralmagneten und Kranzmagneten verbleibt der Bedienknebel in der jeweils gewählten Auswahlstellung 30 und kann dort gedreht werden.

Gemäß Figur 7 kann die Betätigung des Bedienknebels auf alternative Weise wie folgt erfolgen. Zur Auswahl einer Betriebsfunktion, also der gewünschten Kochstelle 8, wird der Bedienknebel von der Bedienperson aus der mittleren Ausgangsstellung 28 in die entsprechende Auswahlstellung 30 geschoben. Nach erfolgter Auswahl einer der Kochstellen 8 verschiebt die Bedienperson den Bedienknebel wieder in die zentrale Ausgangsstellung 28 zurück. Die Einstellung des Betriebsparameters, also der Heizstufe der ausgewählten Kochstelle 8, erfolgt anschließend durch das Drehen des Bedienknebels in der zentralen Ausgangsstellung 28. Zusätzlich oder alternativ kann auch vorgesehen sein, dass beispielsweise eine stufenweise Erhöhung oder Verringerung der Heizstufe einer ausgewählten Kochstelle 8 durch wiederholtes Schieben des Bedienknebels aus der Ausgangsstellung 28 in die entsprechende Auswahlstellung 30 erfolgt.

In beiden gezeigten Varianten ist eine Verbindung der erfindungsgemäßen Funktionalität des Bedienknebels mit zusätzlichen Berührungssensoren vorhanden, um einen unabhängigen Hauptschalter zu realisieren. Das Abnehmen des Bedienknebels während des Betriebs könnte nach einer Warnphase alle Kochstellen abschalten und damit in den Hauptschalter einseitig eingreifen. Diese Warnung kann akustisch und/oder optisch erfolgen. Weitere Funktionen können in beiden Varianten durch mehrmaliges Auslenken in die selbe Richtung auch in einem sogenannten Toggle-Modus belegt werden, wie beispielsweise eine Zonenzuschaltung.

Ein bedeutender Vorteil der erfindungsgemäßen Anordnung der Bedieneinheit liegt darin, dass der zentrale Bedienknebel leicht reinigbar und abnehmbar ist und auf diese Weise auch die Reinigung der völlig planen Glaskeramikplatte ermöglicht, die zudem keinerlei Durchbrüche oder Absätze aufweist. Der gesamte Bedienbereich mit seiner Bedruckung und den in seiner Nähe gruppierten Leuchtmarkierungen kann sehr klein und damit platzsparend ausgeführt sein. Er ist ebenso leicht zu reinigen wie eine Kochmulde mit Berührsteuerung, ohne dass damit deren Nachteile verbunden sind, wie beispielsweise den unvermeidlichen Fingerabdrücken sowie den Wärmeeinflüssen bei der Berührung einer eventuell heißen Glaskeramikoberfläche.

### Bezugszeichenliste

- 2: Kochfeld
- 4: Glaskeramikplatte
- 6: Plattenfacette
- 8: Kochstelle
- 10: Bedienknebel
- 12: Knebelachse
- 14: Haltemagnet
- 16: Knebelunterseite
- 18: Polspinne
- 20: Zentralbereich
- 22: Arm
- 24: Zentralmagnet
- 26: Kranzmagnet
- 28: Ausgangsstellung
- 30: Auswahlstellung
- 31: Signaleinrichtung
- 32: Aktivierungsbereich
- 33: Erste Begrenzung
- 34: Zweite Begrenzung
- N: Nordpol (Magnet)
- S: Südpol (Magnet)

## Patentansprüche

1. Bedieneinheit für ein elektrisches Haushaltsgerät zum Einstellen von Betriebsfunktionen und -parametern mit wenigstens einem auf einer Platte (4) magnetisch gehalterten Bedienknebel (10), der zum Auswählen einer Betriebsfunktion, wie der Auswahl einer Kochstelle (8), aus einer Ausgangsstellung (28) in eine Auswahlstellung (30) schiebbar ist und der zum Einstellen des Betriebsparameters, wie einer Heizstufe, um eine Knebelachse (12) drehbar ist, wobei zur magnetischen Halterung des Bedienknebels (10) im Bereich der Platte (4) eine Magnetanordnung mit mehreren ortsfest angeordneten Magneten (24, 26) vorgesehen ist, die auf wenigstens einen Permanentmagneten (14) und/oder ein ferromagnetisches Element (18) des Bedienknebels (10) eine magnetische Anziehungskraft ausübt und Dreh- und Verschiebebewegungen des Bedienknebels (10) ermöglicht, **dadurch gekennzeichnet, dass** mit zusätzlichen Berührungssensoren ein unabhängiger Hauptschalter realisiert ist, wobei beim Abnehmen des Bedienknebels während des Betriebs die Kochstellen abschaltbar sind.

2. Bedieneinheit nach Anspruch 1, **dadurch gekennzeichnet, dass** eine optische und/oder akustische Signaleinrichtung (31) die Auswahlstellung (30) des Bedienknebels (10) anzeigt.

3. Bedieneinheit nach Anspruch 1 oder 2, **dadurch gekennzeichnet, dass** der Bedienknebel (10) ausgelegt ist, um aus der Auswahlstellung (30) selbsttätig in die Ausgangsstellung (28) zurückzugleiten.

4. Bedieneinheit nach Anspruch 1 oder 2, **dadurch gekennzeichnet, dass** der Bedienknebel (10) ausgelegt ist, um aus der Auswahlstellung (30) durch Zurückschieben in die Ausgangsstellung (28) gebracht zu werden.

5. Bedieneinheit nach einem der vorhergehenden Ansprüche, **dadurch gekennzeichnet, dass** die ortsfest angeordneten Magnete (24, 26) der Magnetanordnung einen Zentralmagneten (24) und eine Anzahl von, insbesondere wenigstens drei, jeweils um diesen verteilte Kranzmagneten (26) aufweisen.

6. Bedieneinheit nach einem der vorhergehenden Ansprüche, **dadurch gekennzeichnet, dass** der Bedienknebel (10) einen Haltemagneten (14) sowie eine ferromagnetischen Scheibe (18) mit wenigstens drei Armen (22) an einer Unterseite (16) des Bedienknebels (10) aufweist.

7. Bedieneinheit nach Anspruch 6, **dadurch gekennzeichnet, dass** die ferromagnetische Scheibe als Polspinne (18) aus Weicheisen gebildet ist.

8. Bedieneinheit nach Anspruch 6 oder 7, **dadurch gekennzeichnet, dass** die Anzahl und die Anordnung von Armen (22) der Polspinne (18) der Anzahl von Kranzmagneten (26) entspricht.

9. Bedieneinheit nach einem der Ansprüche 6 bis 8, **dadurch gekennzeichnet, dass** zur Ausübung der magnetischen Anziehungskraft der Zentralmagnet (24) bzw. die Kranzmagnete (26) dem Haltemagneten (14) des Bedienknebels (10) gegenpolig gegenüberliegen.

10. Bedieneinheit nach einem der Ansprüche 6 bis 9, **dadurch gekennzeichnet, dass** zur Erzeugung von abstoßend wirkenden Magnetkräften die Arme (22) der ferromagnetischen Polspinne bzw. Scheibe (18) den Kranzmagneten (26) bzw. dem Zentralmagneten (24) gleichpolig gegenüberliegen.

11. Bedieneinheit nach einem der vorhergehenden Ansprüche, **dadurch gekennzeichnet, dass** der Bedienknebel (10) zum Einstellen von wenigstens zwei Betriebsfunktionen ausgelegt ist.

12. Bedieneinheit nach einem der vorhergehenden Ansprüche, **dadurch gekennzeichnet, dass** entlang der Platte (4) beabstandet vom Umfang des Zentralmagneten (24) ein Aktivierungsbereich zur Aktivierung der ausgewählten Bedienfunktion (8) vorgesehen ist.

13. Bedieneinheit nach Anspruch 12, **dadurch gekennzeichnet, dass** der Aktivierungsbereich durch eine zum Zentralmagneten (24) benachbarte erste Begrenzung und durch eine zum Zentralmagneten (24) weiter beabstandete zweite Begrenzung begrenzt ist.

14. Bedieneinheit nach Anspruch 13, **dadurch gekennzeichnet, dass** die erste Begrenzung des Aktivierungsbereiches über einen Abstand von wenigstens 5 mm vom Umfang des Zentralmagneten (24) entfernt.

15. Bedieneinheit nach Anspruch 13 oder 14, **dadurch gekennzeichnet, dass** die zweite Begrenzung des Aktivierungsbereiches über einen Abstand bis zu 15 mm vom Umfang des Zentralmagneten (24) entfernt ist.

16. Bedieneinheit nach einem der vorhergehenden Ansprüche, **dadurch gekennzeichnet, dass** die Auswahl der Betriebsfunktion (8) durch den Bedienknebel (10) nur dann erfasst ist, wenn der Bedienknebel (10) nach einem vorgegebenen Zeitintervall wieder in die Ausgangsstellung (28) zurückgestellt ist.

17. Bedieneinheit nach Anspruch 16, **dadurch gekennzeichnet, dass** das vorgegebene Zeitintervall zwischen zwei und fünf Sekunden liegt.

18. Bedieneinheit nach einem der Ansprüche 5 bis 17, **dadurch gekennzeichnet, dass** die Kranzmagnete (26) gleichmäßig um den Umfang des Zentralmagneten (24) verteilt sind.

## Claims

1. Control unit for an electrical domestic appliance for setting operating functions and operating parameters, with at least one control knob (10) which is magnetically mounted on a plate (4) and for selection of an operating function, such as the selection of a cooking position (8), can be pushed from a starting setting (28) into a selection setting (30), and which for setting the operating parameter, such as a heating step, is rotatable about a knob axis (12), wherein provided for magnetic mounting of the control knob (10) in the region of the plate (4) is a magnet arrangement with several magnets (24, 26), arranged to be stationary, which arrangement exerts a magnetic attraction force on at least one permanent magnet (14) and/or ferromagnetic element (18) of the control knob (10) and enables rotational and sliding movements of the control knob (10), **characterised in that** an independent main switch is realised by additional contact sensors, wherein the cooking positions can be switched off by removal of the control knob during operation.

2. Control unit according to claim 1, **characterised in that** an optical and/or acoustic signal device (31) indicates the selection setting (30) of the control knob (10).

3. Control unit according to claim 1 or 2, **characterised in that** the control knob (10) is designed in order to automatically slide back from the selection setting (30) into the starting setting (28).

4. Control unit according to claim 1 or 2, **characterised in that** the control knob (10) is designed to be brought from the selection setting (30) into the starting setting (28) by pushing back.

5. Control unit according to any one of the preceding claims, **characterised in that** the magnets (24, 26), which are arranged to be stationary, of the magnet arrangement comprise a central magnet (24) and a number of, in particular at least three, circle magnets (26) distributed around this.

6. Control unit according to any one of the preceding claims, **characterised in that** the control knob (10) comprises a mounting magnet (14) as well as a ferromagnetic disc (18) with at least three arms (22) at an underside (16) of the control knob (10).

7. Control unit according to claim 6, **characterised in that** the ferromagnetic disc is formed as a pole spider (18) of soft iron.

8. Control unit according to claim 6 or 7, **characterised in that** the number and arrangement of arms (22) of the pole spider (18) correspond with the number of circle magnets (26).

9. Control unit according to any one of claims 6 to 8, **characterised in that** for exertion of the magnetic attraction force the central magnet (24) or the circle magnets (26) is or are disposed with opposite poling opposite the mounting magnet (14) of the control knob (10).

10. Control unit according to any one of claims 6 to 9, **characterised in that** for producing repulsively acting magnetic forces the arms (22) of the ferromagnetic pole spider or disc (18) are disposed with the same poling opposite the circle magnets (26) or the central magnet (24).

11. Control unit according to any one of the preceding claims, **characterised in that** the control knob (10) is designed for setting at least two operating functions.

12. Control unit according to any one of the preceding claims, **characterised in that** an activation region for activation of the selected control function (8) is provided along the plate (4) at a spacing from the circumference of the central magnet (24).

13. Control unit according to claim 12, **characterised in that** the activation region is bounded by a first boundary adjacent to the central magnet (24) and by a second boundary spaced further from the central magnet (24).

14. Control unit according to claim 13, **characterised in that** the first boundary of the activation region is spaced from the circumference of the central magnet by a distance of at least 5 millimetres.

15. Control unit according to claim 13 or 14, **characterised in that** the second boundary of the activation region is spaced from the circumference of the central magnet (24) over a distance of up to 15 millimetres.

16. Control unit according to any one of the preceding claims, **characterised in that** the selection of the operating function (8) by the control knob (10) is detected only when the control knob (10) is restored again to the starting setting (28) after a predetermined time interval.

17. Control unit according to claim 16, **characterised in that** the predetermined time interval is between two and five seconds.

18. Control unit according to any one of claims 5 to 17, **characterised in that** the circle magnets (26) are uniformly distributed around the circumference of the central magnet (24).

## Revendications

1. Unité de commande pour appareil électroménager, servant à régler des fonctions et des paramètres d'utilisation, comprenant au moins une manette de commande (10) maintenue magnétiquement sur une plaque (4), laquelle manette est coulissante d'une position initiale (28) dans une position de sélection (30) pour sélectionner une fonction d'utilisation, telle que la sélection d'une plaque de cuisson (8), et qui est rotative autour d'un axe de manette (12) pour régler le paramètre d'utilisation, tel qu'un niveau de chauffage, un agencement magnétique de plusieurs aimants (24, 26) stationnaires étant prévu dans la zone de la plaque (4) pour le maintien magnétique de la manette de commande (10), lequel agencement exerce une force d'attraction magnétique sur au moins un aimant permanent (14) et/ou un élément ferromagnétique (18) de la manette de commande (10) et permet des mouvements de rotation et de coulissement de la manette de commande (10), **caractérisée en ce qu'**un commutateur principal indépendant est réalisé avec des capteurs de contact supplémentaires, les plaques de cuisson pouvant être coupées si l'on enlève la manette de commande en cours d'utilisation.

2. Unité de commande selon la revendication 1, **caractérisée en ce qu'**un dispositif de signalisation visuelle et/ou acoustique (31) indique la position de sélection (30) de la manette de commande (10).

3. Unité de commande selon la revendication 1 ou 2, **caractérisée en ce que** la manette de commande (10) est conçue pour coulisser en retour automatiquement de la position de sélection (30) à la position initiale (28).

4. Unité de commande selon la revendication 1 ou 2, **caractérisée en ce que** la manette de commande (10) est conçue pour être mise dans la position initiale (28) à partir de la position de sélection (30) par coulissement en arrière.

5. Unité de commande selon l'une des revendications précédentes, **caractérisée en ce que** les aimants (24, 26) stationnaires de l'agencement d'aimants comportent un aimant central (24) et un nombre d'aimants périphériques (26), de notamment au moins trois, répartis respectivement autour de celui-ci.

6. Unité de commande selon l'une des revendications précédentes, **caractérisée en ce que** la manette de commande (10) présente un aimant de maintien (14) ainsi qu'un disque ferromagnétique (18) comprenant au moins trois bras (22) sur un côté inférieur (16) de la manette de commande (10).

7. Unité de commande selon la revendication 6, **caractérisée en ce que** le disque ferromagnétique est réalisé en tant que croisillon à pôles (18) en fer doux.

8. Unité de commande selon la revendication 6 ou 7, **caractérisée en ce que** le nombre et l'agencement de bras (22) du croisillon à pôles (18) correspond au nombre d'aimants périphériques (26).

9. Unité de commande selon l'une des revendications 6 à 8, **caractérisée en ce que**, pour exercer la force d'attraction magnétique, l'aimant central (24) resp. les aimants périphériques (26) sont situés à l'opposé de l'aimant de maintien (14) de la manette de commande (10) de manière antipolaire.

10. Unité de commande selon l'une des revendications 6 à 9, **caractérisée en ce que**, pour générer des forces magnétiques agissant de manière repoussante, les bras (22) du croisillon à pôles ferromagnétique ou disque ferromagnétique (18) se situent à l'opposé des aimants périphériques (26) resp. de l'aimant central (24) de manière homopolaire.

11. Unité de commande selon l'une des revendications précédentes, **caractérisée en ce que** la manette de commande (10) est réalisée pour régler au moins deux fonctions d'utilisation.

12. Unité de commande selon l'une des revendications précédentes, **caractérisée en ce qu'**une zone d'activation permettant l'activation de la fonction de commande sélectionnée (8) est ménagée le long de la plaque (4) à écart de la circonférence de l'aimant central (24).

13. Unité de commande selon la revendication 12, **caractérisée en ce que** la zone d'activation est délimitée par une première délimitation adjacente à l'aimant central (24) et par une seconde délimitation plus écartée de l'aimant central (24).

14. Unité de commande selon la revendication 13, **caractérisée en ce que** la première délimitation de la zone d'activation est éloignée de la circonférence de l'aimant central (24) par l'intermédiaire d'un écart d'au moins 5 mm.

15. Unité de commande selon la revendication 13 ou 14, **caractérisée en ce que** la seconde délimitation de la zone d'activation est éloignée de la circonférence de l'aimant central (24) par l'intermédiaire d'un écart allant jusqu'à 15 mm.

16. Unité de commande selon l'une quelconque des revendications précédentes, **caractérisée en ce que** la sélection de la fonction d'utilisation (8) au moyen de la manette de commande (10) est enregistrée seulement lorsque la manette de commande (10) est remise dans la position initiale (28) après un intervalle de temps prédéterminé.

17. Unité de commande selon la revendication 16, **caractérisée en ce que** l'intervalle de temps prédéterminé se situe entre deux et cinq secondes.

18. Unité de commande selon l'une des revendications 5 à 17, **caractérisée en ce que** les aimants périphériques (26) sont répartis régulièrement autour de la circonférence de l'aimant central (24).
